# FASCICULE DE BREVET EUROPEEN

(11) **EP 2 668 513 B1**
(45) Date de publication et mention de la délivrance du brevet: **25.07.2018**
(21) Numéro de dépôt: 11815500.1
(22) Date de dépôt: 21.12.2011
(51) Int. Cl.: G01R 19/165, G01R 31/00, G01R 31/02, H02H 11/00, B60L 3/00, H01R 13/713

(54) **SYSTÈME À CONNECTEUR ÉLECTRIQUE COMPORTANT UN DISPOSITIF DE DÉTECTION DE DÉFAUT DE CONNEXION À LA TERRE**
ELEKTRISCHES VERBINDERSYSTEM BEINHALTEND EINE VORRICHTUNG ZUR ERKENNUNG EINES ERDSCHLUSSFEHLERS
ELECTRICAL CONNECTOR SYSTEM COMPRISING A DEVICE FOR DETECTING AN EARTH CONNECTION FAULT

(30) Priorité: 26.01.2011 FR 1150611
(43) Date de publication de la demande: 04.12.2013
(73) Titulaire: PSA Automobiles SA, 78300 Poissy (FR)
(72) Inventeur: MORAND, Nicolas, F-92400 Courbevoie (FR)
(74) Mandataire: Jeannin, Laurent Jean-Pierre
(86) Numéro de dépôt international: PCT/FR2011/053128
(87) Numéro de publication internationale: WO 2012/101347

(56) Documents cités:
- EP-A1- 1 383 218
- DE-A1- 3 429 067
- DE-C1- 19 503 749
- GB-A- 2 380 554
- US-A1- 2005 212 526
- US-A1- 2008 036 466
- US-A1- 2008 211 683
- US-A1- 2010 244 849
- US-B1- 7 400 476

## Description

L'invention concerne les systèmes à connecteur électrique, et plus précisément la sécurisation de l'utilisation de tels systèmes lors d'une phase d'alimentation en courant.

On entend ici par "système à connecteur électrique" un système ou équipement comprenant au moins un connecteur électrique destiné à être couplé à un réseau d'alimentation électrique.

L'invention concerne notamment les systèmes tels que les chargeurs de batterie, les prises de connexion murales et les câbles de connexion (en particulier ceux qui sont équipés d'un boîtier électronique de contrôle).

On notera que les chargeurs de batterie peuvent faire partie de tout système ou appareil ou installation, et notamment d'un véhicule, éventuellement de type automobile, et éventuellement de type hybride ou tout électrique, d'un bâtiment, d'une installation publique ou industrielle, d'un aéronef (ou analogue), d'un satellite, d'un équipement électronique grand public, ou d'un équipement ferroviaire. Dans le cas d'un chargeur de batterie, l'invention est notamment destinée à sécuriser les opérations de rechargement des batteries électriques de systèmes (ou appareils ou installations) auprès de points de recharge (publics ou privés).

On entend ici par "point de recharge public" une borne de recharge publique, et par "point de recharge privé" une prise de courant connectée à une portion d'un réseau d'alimentation électrique.

Comme le sait l'homme de l'art, le couplage d'un système à connecteur électrique à un réseau d'alimentation électrique (comme par exemple le "secteur") peut s'avérer potentiellement dangereux. C'est par exemple le cas de certaines batteries électriques (de systèmes) qui doivent être rechargées sous une tension et/ou un courant potentiellement dangereux(se), par couplage à un réseau d'alimentation électrique. Afin que ce rechargement puisse être sécurisé sur le plan électrique pour les personnes qui procèdent au couplage du chargeur électrique d'un système (ou installation) à un point de recharge, il est en général impératif que ces systèmes soient correctement et effectivement connectés à la terre. Cette connexion à la terre se fait via la ligne de terre à laquelle est connecté le point de recharge, en complément de la ligne de neutre et de la (des) ligne(s) de phase. Elle est généralement définie par une norme, comme par exemple la norme ISO/CEI 61851-1.

Il est ici rappelé qu'il existe de nombreux régimes de neutre, et notamment ceux appelés TT ("Terre-Terre"), IT (Isolé-Terre") et TN ("Terre-Neutre").

On comprendra que s'il existe un défaut de mise à la terre au niveau du point de recharge ou du câble de connexion, qui est utilisé pendant une phase d'alimentation (éventuellement destinée à un rechargement de batteries électriques d'un système), cette alimentation peut s'avérer potentiellement dangereux pour la personne qui procède au couplage si elle est en contact avec une pièce métallique sous tension du système.

Afin de détecter des défauts de connexion à la ligne de terre, plusieurs solutions ont été proposées dans le domaine des véhicules hybrides ou électriques.

Une première solution, notamment décrite dans le document brevet US 2010/244849, consiste à comparer des paramètres électriques avec des valeurs de référence, avec injection de signaux alternatifs, dans le cas de systèmes de rechargement de véhicules électriques, dont une partie doit rester reliée à la terre pour permettre le fonctionnement du système. Cette première solution ne peut être mise en oeuvre qu'une fois que le rechargement a effectivement commencé, et donc la personne qui effectue un couplage est potentiellement en danger tant que la vérification de défaut de connexion à la ligne de terre n'est pas terminée.

Une seconde solution, notamment décrite dans le document brevet JP 2010/178422, consiste à combiner au signal de recharge continu, délivré par un point de recharge, un signal auxiliaire de détection présentant une fréquence auxiliaire choisie, et en cas de détermination de variations de cette fréquence auxiliaire à estimer des valeurs de tension maximale et minimale correspondant à ces variations, afin de déterminer si l'on a effectivement un défaut de connexion à la terre. Cette seconde solution ne peut être mise en oeuvre qu'une fois que le rechargement a effectivement commencé, et donc la personne qui effectue un couplage est potentiellement en danger tant que la vérification de défaut de connexion à la ligne de terre n'est pas terminée. La demande de brevet EP1383218 A1 divulgue un dispositif de surveillance de rupture de neutre et de terre selon le préambule de la revendication 1. L'invention a donc pour but d'améliorer la situation, notamment en permettant d'effectuer une vérification de défaut de connexion à la ligne de terre entre un système à connecteur électrique et un réseau d'alimentation électrique.

Elle propose notamment à cet effet un dispositif de détection, destiné à équiper un système à connecteur électrique destiné à être couplé à un réseau d'alimentation électrique comportant une ligne de terre, et au moins une ligne de phase et une ligne de neutre ayant une différence de tension principale, ce système à connecteur électrique comportant des première et deuxième lignes propres à être couplées respectivement aux lignes de neutre et de phase, ou inversement, et une troisième ligne propre à être couplée à la ligne de terre.

Ce dispositif de détection se caractérise par le fait qu'il comprend:
- des premiers moyens de mesure propres à être connectés entre les première et troisième lignes, alors que ces dernières sont couplées par une première impédance, afin de mesurer une première différence de tension entre elles, et/ou
- des seconds moyens de mesure propres à être connectés entre les deuxième et troisième lignes, alors que ces dernières sont couplées par une deuxième impédance, afin de mesurer une seconde différence de tension entre elles, et
- des moyens de traitement agencés pour déterminer, avant que le rechargement ne commence, si l'une au moins des première et seconde différences de tension appartient à une plage de valeurs correspondante, et, dans la négative, pour générer un signal d'alarme signalant un défaut de connexion à la ligne de terre.

Le dispositif de détection selon l'invention peut comporter d'autres caractéristiques qui peuvent être prises séparément ou en combinaison, et notamment :
- il peut comprendre les première et seconde impédances;
- chaque plage de valeurs peut être fonction de la différence de tension principale et d'un rapport fonction des première et seconde impédances,
- en présence de première et deuxième lignes propres à être couplées respectivement aux lignes de neutre et de phase, ses moyens de traitement peuvent être agencés pour déterminer si la première différence de tension appartient à une première plage de valeurs correspondante. Dans une variante, en présence de première et deuxième lignes propres à être couplées respectivement aux lignes de phase et de neutre, ses moyens de traitement peuvent être agencés pour déterminer si la seconde différence de tension appartient à une seconde plage de valeurs correspondante;
   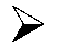 ses moyens de traitement peuvent être agencés pour considérer que la différence de tension principale est la plus importante des différences de tension parmi les première et seconde différences de tension;
- en présence d'une différence de tension principale de type alternative, ses premiers moyens de mesure peuvent comprendre i) des moyens de division de type analogique et agencés pour diviser la première différence de tension par une constante choisie afin de délivrer un premier signal intermédiaire analogique, ii) des moyens de redressement de type analogique et agencés pour redresser ce premier signal intermédiaire analogique afin de délivrer un deuxième signal intermédiaire analogique, iii) des moyens de filtrage de type analogique et agencés pour appliquer un filtrage passe-bas à ce deuxième signal intermédiaire analogique afin de délivrer un troisième signal intermédiaire analogique, et iv) des moyens de conversion agencés pour convertir ce troisième signal intermédiaire analogique afin de délivrer un signal de sortie numérique, représentatif de la première différence de tension;
- en présence d'une différence de tension principale de type alternative, ses seconds moyens de mesure peuvent comprennent i) des moyens de division de type analogique et agencés pour diviser la seconde différence de tension par une constante choisie afin de délivrer un premier signal intermédiaire analogique, ii) des moyens de redressement de type analogique et agencés pour redresser ce premier signal intermédiaire analogique afin de délivrer un deuxième signal intermédiaire analogique, iii) des moyens de filtrage de type analogique et agencés pour appliquer un filtrage passe-bas à ce deuxième signal intermédiaire analogique afin de délivrer un troisième signal intermédiaire analogique, et iv) des moyens de conversion agencés pour convertir ce troisième signal intermédiaire analogique afin de délivrer un signal de sortie numérique, représentatif de la seconde différence de tension.

L'invention propose également un système à connecteur électrique comportant, d'une part, des première et deuxième lignes propres à être couplées respectivement à des lignes de neutre et de phase, ou inversement, d'un réseau d'alimentation électrique, et une troisième ligne propre à être couplée à une ligne de terre de ce réseau électrique, et, d'autre part, un dispositif de détection du type de celui présenté ci-avant.

Un tel système à connecteur électrique peut, par exemple, être un chargeur de batterie ou une prise de connexion murale ou bien un câble de connexion.

L'invention propose également un système comportant au moins une batterie électrique rechargeable à un point de recharge et un système à connecteur électrique du type de celui présenté ci-avant.

Un tel système peut, par exemple, constituer un véhicule, éventuellement de type automobile, et éventuellement de type hybride ou de type tout électrique.

D'autres caractéristiques et avantages de l'invention apparaîtront à l'examen de la description détaillée ci-après, et des dessins annexés, sur lesquels :
- la figure 1 illustre schématiquement et fonctionnellement un véhicule comprenant un connecteur électrique, pourvu d'un exemple de réalisation d'un dispositif de détection selon l'invention et couplé, via un câble de connexion, à une prise de courant murale, constituant un point de recharge connecté à un réseau d'alimentation électrique disposant d'un régime de neutre de type TT,
- la figure 2 illustre schématiquement et fonctionnellement le véhicule de la figure 1 couplé à une prise de courant murale, constituant un point de recharge connecté à un réseau d'alimentation électrique disposant d'un régime de neutre de type IT,
- la figure 3 illustre schématiquement et fonctionnellement le véhicule de la figure 1 couplé à une prise de courant murale, constituant un point de recharge connecté à un réseau d'alimentation électrique disposant d'un régime de neutre de type TN, et
- la figure 4 illustre schématiquement et fonctionnellement un exemple de réalisation de premiers moyens de mesure d'un dispositif de détection selon l'invention, adapté à une tension alternative de recharge.

Les dessins annexés pourront non seulement servir à compléter l'invention, mais aussi contribuer à sa définition, le cas échéant.

L'invention a pour but d'offrir un système à connecteur électrique (CV) comportant un dispositif de détection afin de permettre la détection d'un défaut de connexion de ce système (CV) à une ligne de terre (LT) d'un réseau d'alimentation électrique (RA).

Dans ce qui suit, on considère, à titre d'exemple non limitatif, que le système à connecteur électrique (CV) fait partie d'un système (V). Mais, cela n'est pas obligatoire. Il peut en effet constituer un équipement indépendant destiné à être couplé à au moins un autre équipement ou système ou installation ou encore appareil.

Par ailleurs, on considère dans ce qui suit, à titre d'exemple non limitatif, que les systèmes (V) sont des véhicules de type automobile. Il s'agit par exemple de voitures de type tout électrique ou hybride. Mais, l'invention n'est pas limitée à ce type de système. Elle concerne en effet tout type de système (ou appareil ou installation), et notamment ceux qui comportent au moins une batterie électrique (BA) qui peut être rechargée auprès d'un point de recharge (PC) public (borne de recharge publique) ou privé (prise de courant murale connectée à une portion d'un réseau d'alimentation électrique (RA)). Ainsi, elle concerne également les bâtiments, les installations industrielles et publiques, l'aéronautique, l'électronique grand public, et le domaine ferroviaire.

De plus, on considère dans ce qui suit, à titre d'exemple non limitatif, que le système à connecteur électrique (CV) est un chargeur de batterie. Mais, l'invention n'est pas limitée à ce type de système. Elle concerne en effet tout type de système disposant d'au moins un connecteur électrique, et notamment les prises de connexion murales et les câbles de connexion (en particulier ceux qui sont équipés d'un boîtier électronique de contrôle).

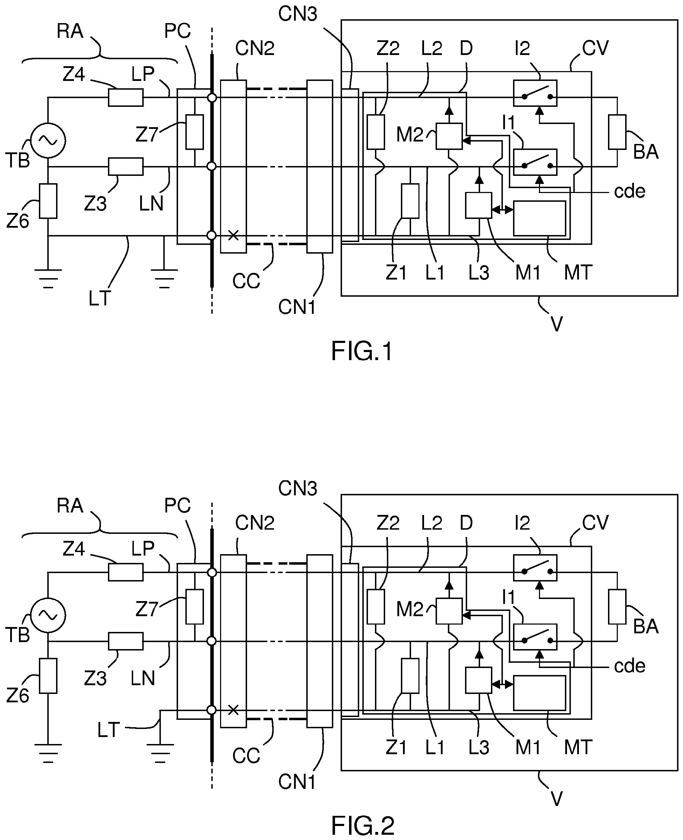

On a schématiquement représenté sur les figures 1 à 3 un système V (ici un véhicule) comprenant une batterie BA couplée à un système à connecteur électrique CV (ici un chargeur de batterie) qui est lui même couplé à un point de recharge PC via un câble de connexion CC.

Dans les exemples non limitatifs illustrés sur les figures 1 à 3, le point de recharge PC est une prise de courant murale qui est connectée à une portion d'un réseau d'alimentation électrique (ou "secteur") RA. Mais, dans une variante, le point de recharge pourrait être une borne de recharge publique connectée à une portion d'un réseau d'alimentation électrique.

Le réseau d'alimentation électrique RA est ici de type monophasé, à titre d'exemple non limitatif. Il comprend donc une ligne de neutre LN, dont l'impédance est matérialisée par le rectangle Z3, une unique ligne de phase LP, dont l'impédance est matérialisée par le rectangle Z4, et une ligne de terre LT, dont l'impédance est éventuellement matérialisée par le rectangle Z5.

Il est important de noter que l'invention concerne également les réseaux triphasés. On comprendra plus loin que dans le cas d'un réseau triphasé, la description qui suit peut être transposée à l'une quelconque des trois lignes de phase de ce réseau triphasé.

Le réseau d'alimentation électrique RA comprend également un transformateur basse tension TB qui fournit à la prise (de courant) murale PC, via la portion de réseau à laquelle elle est connectée et donc via les lignes de phase LP et de neutre LN, un signal de recharge alternatif ou continu. La ligne de neutre LN est connectée à la terre par une impédance Z6.

La différence de tension V0, dite principale, qui existe entre les lignes de phase LP et de neutre LN, est la tension (ou signal de recharge) qui est délivré(e) par le transformateur basse tension TB.

Ce qui différencie les trois figures 1 à 3, c'est le régime de neutre qui est assuré par la portion de réseau à laquelle est connectée la prise murale PC.

Dans l'exemple de la figure 1, le régime de neutre est de type TT. La terre de la prise murale PC et la terre du réseau d'alimentation électrique RA sont interconnectées via la ligne de terre LT. Dans ce cas, l'impédance Z6 est voisine de 0 Ω et on n'a pas d'impédance Z5.

Dans l'exemple de la figure 2, le régime de neutre est de type IT. La terre de la prise murale PC et la terre du réseau d'alimentation électrique RA sont indépendantes. Dans ce cas, l'impédance Z6 est généralement voisine de 1 kΩ.

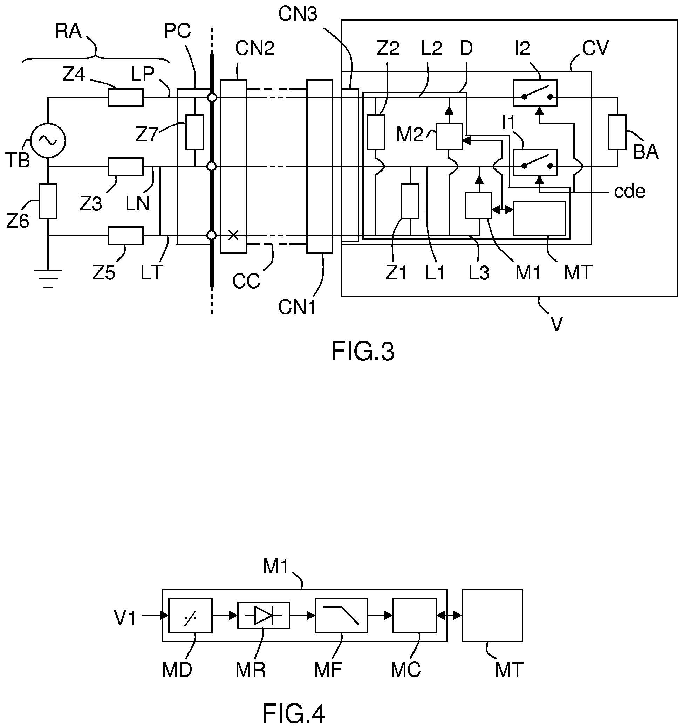

Dans l'exemple de la figure 3, le régime de neutre est de type TN. La terre de la prise murale PC et la terre du réseau d'alimentation électrique RA sont interconnectées via la ligne de terre LT, et les lignes de terre LT et de neutre LN sont interconnectées. Dans ce cas, l'impédance Z6 est voisine de 0 Ω et l'impédance de l'interconnexion entre les lignes de terre LT et de neutre LN est également voisine de 0 Ω.

Il est important de noter que l'invention ne concerne pas seulement les régimes de neutre présentés ci-avant en référence aux figures 1 à 3. Elle concerne également toutes leurs variantes, ainsi que de nombreux autres régimes de neutre.

La prise murale PC comprend trois bornes matérialisées par des cercles blancs et qui sont respectivement connectées aux lignes de neutre LN, de phase LP et de terre LT.

L'impédance des autres équipements qui sont connectés au réseau d'alimentation électrique RA en amont de la prise murale PC est matérialisée par le rectangle référencé Z7. Cette impédance Z7 a une valeur élevée devant les impédances Z3 et Z4.

Le câble de connexion CC, qui est utilisé pour coupler le système à connecteur électrique CV (ici un chargeur de batterie) du véhicule V à la prise murale PC, comprend deux connecteurs CN1 et CN2 interconnectés par trois lignes (ou câbles électriques) destinées à être connectées aux lignes de neutre LN, de phase LP et de terre LT de la prise murale PC. Ici le premier connecteur CN1 est couplé au connecteur électrique CN3 du système à connecteur électrique CV du véhicule V, tandis que le second connecteur CN2 est couplé à la prise murale PC.

Le système à connecteur électrique CV du véhicule V comprend, d'une part, des première L1 et deuxième L2 lignes (ou câbles électriques) qui sont connectées à son connecteur électrique CN3 et qui sont destinées à être couplées respectivement aux lignes de neutre LN et de phase LP de la prise murale PC, ou inversement, et, d'autre part, une troisième ligne L3 qui est destinée à être couplée à la ligne de terre LT de cette prise murale PC.

L'expression "ou inversement" est ici utilisée pour indiquer que l'on peut avoir soit les première L1 et deuxième L2 lignes couplées respectivement aux lignes de neutre LN et de phase LP, soit les première L1 et deuxième L2 lignes couplées respectivement aux lignes de phase LP et de neutre LN. En effet, il arrive fréquemment que l'on ne sache pas à quelles lignes d'un réseau RA, parmi ses lignes de neutre LN et de phase LP, sont connectées deux des trois bornes de connexion d'un point de recharge PC, en particulier lorsque ce dernier (PC) est une prise murale.

L'invention est donc adaptée à cette diversité de situations.

Le système à connecteur électrique CV peut également comporter, comme illustré non limitativement, des premiers I1 et second I2 moyens de commutation connectés respectivement en série à ses première L1 et deuxième L2 lignes et au circuit de recharge de la batterie électrique BA. Ces premiers I1 et second I2 moyens de commutation sont commandés par des signaux cde qui sont fournis par un équipement de gestion de la recharge qui est implanté dans le véhicule V. Il peut s'agir, par exemple, de transistors, éventuellement de puissance, ou bien d'interrupteurs électro-mécaniques.

On notera que ces premiers I1 et second I2 moyens de commutation pourraient être externes au système à connecteur électrique CV.

Il est important de noter que la mise en oeuvre de l'invention requiert la présence d'un pont diviseur (ou analogue) à l'intérieur du système à connecteur électrique CV.

Ce pont diviseur est au moins constitué d'une première impédance Z1, qui interconnecte les première L1 et troisième L3 lignes du système à connecteur électrique CV, et d'une seconde impédance Z2, qui interconnecte les deuxième L2 et troisième L3 lignes du système à connecteur électrique CV. Il existe ainsi entre les première Z1 et seconde Z2 impédances un point commun qui est placé au potentiel électrique de la troisième ligne L3, laquelle est censée être couplée à la ligne de terre LT.

Ces première Z1 et seconde Z2 impédances peuvent être, par exemple des condensateurs (éventuellement chimiques) ou des composants électroniques capacitifs et/ou inductifs. Généralement, ces première Z1 et seconde Z2 impédances ont des valeurs d'impédance peu différentes, voire parfois sensiblement identiques.

Il est important de noter que les première Z1 et seconde Z2 impédances peuvent soit faire partie du dispositif de détection D, selon l'invention, comme illustré non limitativement sur les figures 1 à 3, soit faire partie du système à connecteur électrique CV tout en étant externes à son dispositif de détection D. Par conséquent, il est possible d'adapter un système à connecteur électrique CV de l'art antérieur, déjà équipé de première Z1 et seconde Z2 impédances agencées en pont diviseur (ou analogue), en lui adjoignant un dispositif de détection D (sans première Z1 et seconde Z2 impédances).

Comme illustré non limitativement sur les figures 1 à 3, un dispositif de détection D, selon l'invention, comprend au moins des premiers moyens de mesure M1 et/ou des seconds moyens de mesure M2, et des moyens de traitement MT.

L'expression "et/ou" est ici utilisée pour indiquer que l'on peut avoir trois modes de réalisation différents: un premier ne comprenant que des premiers moyens de mesure M1, adapté au cas où l'on sait que les première L1 et deuxième L2 lignes sont couplées respectivement aux lignes de neutre LN et de phase LP, un deuxième ne comprenant que des seconds moyens de mesure M2, adapté au cas où l'on sait que les première L1 et deuxième L2 lignes sont couplées respectivement aux lignes de phase LP et de neutre LN, et un troisième comprenant à la fois des premiers M1 et seconds M2 moyens de mesure, adapté à toutes les situations.

Les premiers moyens de mesure M1 sont destinés à être connectés entre les première L1 et troisième L3 lignes (lorsque ces dernières (L1, L3) sont couplées par la première impédance Z1), afin de pouvoir mesurer une première différence de tension V1 entre ces première L1 et troisième L3 lignes.

Les seconds moyens de mesure M2 sont destinés à être connectés entre les deuxième L2 et troisième L3 lignes (lorsque ces dernières (L2, L3) sont couplées par la seconde impédance Z2), afin de pouvoir mesurer une seconde différence de tension V2 entre ces deuxième L2 et troisième L3 lignes.

Les moyens de traitement MT sont couplés aux premiers M1 et/ou seconds M2 moyens de mesure. Ils peuvent être implantés dans le système à connecteur électrique CV, comme illustré non limitativement sur les figures 1 à 3, ou bien dans un autre équipement ou élément du véhicule V.

Ils sont agencés pour déterminer, par exemple et avantageusement avant que ne commence un rechargement de la batterie électrique BA de leur véhicule V (par exemple lorsque les premiers I1 et second I2 moyens de commutation sont tous les deux ouverts (ou non passants)), si l'une au moins des première V1 et seconde V2 différences de tension appartient à une plage de valeurs correspondante. On notera qu'au moins dans le cas d'un système à connecteur électrique de type prise de connexion murale ou câble de connexion (éventuellement à boîtier électronique de contrôle), cette détermination peut se faire à tout moment.

Puis, si l'une au moins des première V1 et seconde V2 différences de tension n'appartient pas à la plage de valeurs correspondante, les moyens de traitement MT génèrent un signal d'alarme qui est destiné à signaler un défaut de connexion à la ligne de terre LT.

L'homme de l'art comprendra en effet qu'en raison de l'agencement des première Z1 et seconde Z2 impédances par rapport aux première L1 et deuxième L2 lignes, s'il n'y a pas de défaut de connexion à la ligne de terre LT et que dans le même temps les première L1 et deuxième L2 lignes sont couplées respectivement aux lignes de neutre LN et de phase LP, alors la différence de tension entre les première L1 et deuxième L2 lignes doit être voisine de la différence de tension principale V0 et donc la première différence de tension V1 doit être faible devant la différence de tension entre les première L1 et deuxième L2 lignes, et donc doit appartenir à une première plage de valeurs (connue à l'avance (par étude) ou calculable, par exemple en fonction des première Z1 et seconde Z2 impédances et de la différence de tension principale V0). Par exemple, avec des impédances Z3, Z4 et Z5 faibles devant l'impédance Z7, et avec une impédance Z1 peu différente de l'impédance Z2, la valeur absolue de la première différence de tension V1 est proche de la moitié de la tension principale V0 s'il y a un défaut de connexion à la ligne de terre LT, et proche de 0 V s'il n'y en a pas. Par conséquent, il suffit de vérifier si la première différence de tension V1 appartient à une première plage de valeurs pour déterminer si l'on est en présence, ou non, d'un défaut de connexion à la ligne de terre LT.

De même, s'il n'y a pas de défaut de connexion à la ligne de terre LT et que dans le même temps les première L1 et deuxième L2 lignes sont couplées respectivement aux lignes de phase LP et de neutre LN, alors la différence de tension entre les première L1 et deuxième L2 lignes doit être voisine de la différence de tension principale V0 et donc la seconde différence de tension V2 doit être faible devant la différence de tension entre les première L1 et deuxième L2 lignes, et donc doit appartenir à une seconde plage de valeurs (connue à l'avance (par étude) ou calculable, par exemple en fonction des première Z1 et seconde Z2 impédances et de la différence de tension principale V0). Par exemple, avec des impédances Z3, Z4 et Z5 faibles devant l'impédance Z7, et avec une impédance Z1 peu différente de l'impédance Z2, la valeur absolue de la seconde différence de tension V2 est proche de la moitié de la tension principale V0 s'il y a un défaut de connexion à la ligne de terre LT, et proche de 0 V s'il n'y en a pas. Par conséquent, il suffit de vérifier si la seconde différence de tension V2 appartient à une seconde plage de valeurs pour déterminer si l'on est en présence, ou non, d'un défaut de connexion à la ligne de terre LT.

Lorsque l'on ne sait pas du tout à quelles lignes du réseau RA sont couplées les première L1 et deuxième L2 lignes, alors on doit vérifier, d'une part, si la première différence de tension V1 appartient à une première plage de valeurs, et, d'autre part, si la seconde différence de tension V2 appartient à une seconde plage de valeurs. Dans cette situation, si l'on est en présence d'un défaut de connexion à la ligne de terre LT l'une au moins des première V1 et seconde V2 différences de tension doit être en dehors de la plage de valeurs correspondante (première ou seconde). Par exemple, avec des impédances Z3, Z4 et Z5 faibles devant l'impédance Z7, et avec une impédance Z1 peu différente de l'impédance Z2, il y a un défaut de connexion à la ligne de terre LT si la valeur absolue de la première différence de tension V1 est proche de la tension principale V0 et si la valeur absolue de la deuxième différence de tension V2 est proche de la moitié de cette tension principale V0, ou si la valeur absolue de la deuxième différence de tension V2 est proche de la tension principale V0 et si la valeur absolue de la première différence de tension V1 est proche de la moitié de cette tension principale V0.

Si le dispositif D ne comprend que des premiers moyens de mesure M1, ses moyens de traitement MT déterminent si la première différence de tension V1 appartient à une première plage de valeurs correspondante. Si la première différence de tension V1 n'appartient pas à la première plage de valeurs correspondante, cela signifie qu'il y a un défaut de connexion à la ligne de terre LT. Par conséquent, les moyens de traitement MT génèrent un signal d'alarme qui est destiné à signaler ce défaut de connexion à la ligne de terre LT. En revanche, si la première différence de tension V1 appartient à la première plage de valeurs correspondante, cela signifie qu'il n'y a pas de défaut de connexion à la ligne de terre LT. Par conséquent, les moyens de traitement MT cessent leur intervention relative à l'invention.

Si le dispositif D ne comprend que des seconds moyens de mesure M2, ses moyens de traitement MT déterminent si la seconde différence de tension V2 appartient à une seconde plage de valeurs correspondante. Si la seconde différence de tension V2 n'appartient pas à la seconde plage de valeurs correspondante, cela signifie qu'il y a un défaut de connexion à la ligne de terre LT. Par conséquent, les moyens de traitement MT génèrent un signal d'alarme qui est destiné à signaler ce défaut de connexion à la ligne de terre LT. En revanche, si la seconde différence de tension V2 appartient à la seconde plage de valeurs correspondante, cela signifie qu'il n'y a pas de défaut de connexion à la ligne de terre LT. Par conséquent, les moyens de traitement MT cessent leur intervention relative à l'invention.

Si le dispositif D comprend à la fois des premiers M1 et seconds M2 moyens de mesure, ses moyens de traitement MT déterminent, d'une part, si la première différence de tension V1 appartient à une première plage de valeurs correspondante, et, d'autre part, si la seconde différence de tension V2 appartient à une seconde plage de valeurs correspondante.

Si l'une au moins des première V1 et seconde V2 différences de tension n'appartient pas à la première ou seconde plage de valeurs correspondante, alors que l'autre différence de tension est proche de la tension principale V0, cela signifie qu'il y a un défaut de connexion à la ligne de terre LT. Par conséquent, les moyens de traitement MT génèrent un signal d'alarme qui est destiné à signaler ce défaut de connexion à la ligne de terre LT. En revanche, si les première V1 et seconde V2 différences de tension appartiennent respectivement aux première et seconde plages de valeurs correspondantes, cela signifie qu'il n'y a pas de défaut de connexion à la ligne de terre LT. Par conséquent, les moyens de traitement MT cessent leur intervention relative à l'invention.

On notera que ce dernier mode de réalisation ne nécessite pas forcément que la différence de tension principale V0 soit connue des moyens de traitement MT. Par conséquent, si tel n'est pas le cas, les moyens de traitement MT sont agencés pour déterminer la différence de tension principale V0 en considérant qu'il s'agit de la plus importante des différences de tension parmi V1 et V2, quand il s'agit d'une valeur suffisamment élevée.

Lorsque la différence de tension principale V0 est de type alternative (ce qui n'est pas obligatoire), les premiers M1 et/ou les seconds M2 moyens de mesure peuvent être agencés comme illustré non limitativement sur la figure 4.

Dans cet exemple de réalisation (non limitatif), les premiers M1 et/ou les seconds M2 moyens de mesure comprennent:
- des moyens de division MD de type analogique et agencés pour diviser la première V1 ou seconde V2 différence de tension par une constante choisie (par exemple égale à 250), afin de délivrer un premier signal intermédiaire analogique, situé par exemple dans la gamme de 0 V à 1 V en valeur efficace.
- des moyens de redressement MR de type analogique et agencés pour redresser le premier signal intermédiaire analogique afin de délivrer un deuxième signal intermédiaire analogique qui ne comprend que des valeurs supérieures ou égales à zéro,
- des moyens de filtrage MF de type analogique et agencés pour appliquer un filtrage passe-bas au deuxième signal intermédiaire analogique afin de délivrer un troisième signal intermédiaire analogique proche du continu et dont la valeur est supérieure ou égale à un seuil, et
- des moyens de conversion MC agencés pour convertir le troisième signal intermédiaire analogique afin de délivrer un signal de sortie numérique, représentatif de ladite première V1 ou seconde V2 différence de tension.

Bien entendu d'autres modes de réalisation des premiers M1 et/ou seconds M2 moyens de mesure peuvent être envisagés, qu'ils soient de type purement analogique ou de type analogique-numérique.

On notera que les moyens de traitement MT sont préférentiellement agencés sous la forme d'une combinaison de modules logiciels et de circuits électroniques (ils peuvent ainsi constituer un circuit logique programmable, comme par exemple un FPGA ("Field Programmable Gate Array") ou un ASIC ("Application-Specific Integrated Circuit"), par exemple). Mais, ils pourraient également être réalisés sous la forme de circuits électroniques ou bien de modules logiciels (par exemple implantés dans un calculateur du véhicule V).

On notera que le signal d'alarme qui est généré par les moyens de traitement MT peut être de type analogique ou numérique. Par ailleurs, ce signal d'alarme peut être utilisé de différentes manières, et notamment par un calculateur implanté dans le véhicule V. Ainsi, il peut servir d'événement déclenchant une interdiction de rechargement de la batterie électrique BA du véhicule V, et/ou l'allumage d'un voyant lumineux, de préférence situé au niveau du système à connecteur électrique CV ou dans son voisinage immédiat (côté extérieur) ou encore sur le tableau de bord du véhicule, et/ou l'affichage d'un message d'alarme sur un écran du véhicule V, et/ou l'émission d'un signal d'alarme par un haut-parleur ou un buzzer du véhicule V ou du système à connecteur électrique CV, et/ou l'émission d'un message d'alarme par synthèse vocale par un haut-parleur du véhicule V ou du système à connecteur électrique CV.

A titre d'exemple, l'interdiction du rechargement de la batterie électrique BA peut se faire en adressant aux premiers I1 et second I2 moyens de commutation un signal de commande cde leur ordonnant de se placer dans leur état ouvert (non passant).

L'invention ne se limite pas aux modes de réalisation de système à connecteur électrique et de système décrits ci-avant, seulement à titre d'exemple, mais elle englobe toutes les variantes que pourra envisager l'homme de l'art dans le cadre des revendications ci-après.

## Revendications

1. Système à connecteur électrique (CV) propre à être couplé à un réseau d'alimentation électrique (RA) comportant une ligne de terre (LT), et au moins une ligne de phase (LP) et une ligne de neutre (LN) ayant une différence de tension principale (V0), ledit système à connecteur électrique (CV) comportant des première (L1) et deuxième (L2) lignes propres à être couplées respectivement auxdites lignes de neutre (LN) et de phase (LP), ou inversement, et une troisième ligne (L3) propre à être couplée à ladite ligne de terre (LT), ledit système à connecteur comportant un dispositif de détection (D), lesdites première (L1) et troisième (L3) lignes étant couplées par une première impédance (Z1) ;
lesdites deuxième (L2) et troisième (L3) lignes étant couplées par une deuxième impédance (Z2) ;
et le dispositif de détection (D) comprenant i) des premiers moyens de mesure (M1) propres à être connectés entre lesdites première (L1) et troisième (L3) lignes, afin de mesurer une première différence de tension (V1) entre elles, et/ou ii) des seconds moyens de mesure (M2) propres à être connectés entre lesdites deuxième (L2) et troisième (L3) lignes, afin de mesurer une seconde différence de tension (V2) entre elles, **caractérisé en ce que** le dispositif de détection comprend iii) des moyens de traitement (MT) agencés pour déterminer si l'une au moins desdites première (V1) et seconde (V2) différences de tension appartient à une plage de valeurs correspondante, et, dans la négative, pour générer un signal d'alarme signalant un défaut de connexion à ladite ligne de terre (LT).

2. Système à connecteur électrique (CV) selon la revendication 1, **caractérisé en ce que** les première (Z1) et seconde (Z2) impédances font partie du dispositif de détection (D).

3. Système à connecteur électrique (CV) selon la revendication 1, **caractérisé en ce que** les première (Z1) et seconde (Z2) impédances sont externes au dispositif de détection (D).

4. Système à connecteur électrique (CV) selon l'une des revendications 1 et 2, **caractérisé en ce que** chaque plage de valeurs correspondante est fonction de ladite différence de tension principale (V0) et d'un rapport fonction desdites première (Z1) et seconde (Z2) impédances.

5. Système à connecteur électrique (CV) selon l'une des revendications 1 à 3, **caractérisé en ce qu'**en présence de première (L1) et deuxième (L2) lignes propres à être couplées respectivement auxdites lignes de neutre (LN) et de phase (LP), lesdits moyens de traitement (MT) sont agencés pour déterminer si ladite première différence de tension (V1) appartient à une première plage de valeurs correspondante.

6. Système à connecteur électrique (CV) selon l'une des revendications 1 à 3, **caractérisé en ce qu'**en présence de première (L1) et deuxième (L2) lignes propres à être couplées respectivement auxdites lignes de phase (LP) et de neutre (LN), lesdits moyens de traitement (MT) sont agencés pour déterminer, avant que le rechargement ne commence, si ladite seconde différence de tension (V2) appartient à une seconde plage de valeurs correspondante.

7. Système à connecteur électrique (CV) selon l'une des revendications 4 et 5, **caractérisé en ce que** lesdits moyens de traitement (MT) sont agencés pour considérer que ladite différence de tension principale (V0) est la plus importante des différences de tension parmi lesdites première et seconde différences de tension.

8. Système à connecteur électrique (CV) selon l'une des revendications 1 à 6, **caractérisé en ce qu'**en présence d'une différence de tension principale (V0) de type alternative, lesdits premiers moyens de mesure (M1) comprennent i) des moyens de division (MD) de type analogique et agencés pour diviser ladite première différence de tension (V1) par une constante choisie afin de délivrer un premier signal intermédiaire analogique, ii) des moyens de redressement (MR) de type analogique et agencés pour redresser ledit premier signal intermédiaire analogique afin de délivrer un deuxième signal intermédiaire analogique, iii) des moyens de filtrage (MF) de type analogique et agencés pour appliquer un filtrage passe-bas audit deuxième signal intermédiaire analogique afin de délivrer un troisième signal intermédiaire analogique proche du continu, et iv) des moyens de conversion (MC) agencés pour convertir ledit troisième signal intermédiaire analogique afin de délivrer un signal de sortie numérique, représentatif de ladite première différence de tension (V1).

9. Système à connecteur électrique (CV) selon l'une des revendications 1 à 7, **caractérisé en ce qu'**en présence d'une différence de tension principale (V0) de type alternative, lesdits seconds moyens de mesure (M2) comprennent i) des moyens de division (MD) de type analogique et agencés pour diviser ladite seconde différence de tension (V2) par une constante choisie afin de délivrer un premier signal intermédiaire analogique, ii) des moyens de redressement (MR) de type analogique et agencés pour redresser ledit premier signal intermédiaire analogique afin de délivrer un deuxième signal intermédiaire analogique, iii) des moyens de filtrage (MF) de type analogique et agencés pour appliquer un filtrage passe-bas audit deuxième signal intermédiaire analogique afin de délivrer un troisième signal intermédiaire analogique proche du continu, et iv) des moyens de conversion (MC) agencés pour convertir ledit troisième signal intermédiaire analogique afin de délivrer un signal de sortie numérique, représentatif de ladite seconde différence de tension (V2).

10. Système à connecteur électrique (CV) selon l'une des revendications précédentes, **caractérisé en ce qu'**il est choisi dans un groupe comprenant au moins un chargeur de batterie, une prise de connexion murale et un câble de connexion.

11. Système (V) comportant au moins une batterie électrique (BA) rechargeable à un point de recharge (PC), **caractérisé en ce qu'**il comprend un système à connecteur électrique (CV) selon l'une des revendications 9 et 10.

12. Système selon la revendication 11, **caractérisé en ce qu'**il constitue un véhicule.

13. Système selon la revendication 12, **caractérisé en ce qu'**il constitue un véhicule automobile de type hybride ou de type tout électrique.

## Patentansprüche

1. Elektrisches Verbindungssystem (CV), das geeignet ist, um mit einem Stromversorgungsnetz (RA) gekoppelt zu sein, das einen Erdleiter (LT) und mindestens einen Phasenleiter (LP) und einen Nullleiter (LN), der einen Hauptspannungsunterschied (V0) hat, umfasst, wobei das elektrische Verbindungssystem (CV) eine erste (L1) und eine zweite (L2) Leitung umfasst, die geeignet sind, jeweils mit dem Nullleiter (LN) und Phasenleiter (LP) oder umgekehrt gekoppelt zu sein, und eine dritte Leitung (L3), die geeignet ist, mit dem Erdleiter (LT) gekoppelt zu sein, wobei das elektrische Verbindungssystem eine Erfassungsvorrichtung (D) umfasst, wobei die erste (L1) und die dritte (L3) Leitung durch ein erstes Impedanzglied (Z1) gekoppelt sind, wobei die zweite (L2) und die dritte (L3) Leitung durch ein zweites Impedanzglied (Z2) gekoppelt sind; und wobei die Erfassungsvorrichtung (D) i) erste Messmittel (M1) umfasst, die geeignet sind, um zwischen der ersten (L1) und der dritten (L3) Leitung angeschlossen zu sein, um einen ersten Spannungsunterschied (V1) zwischen ihnen zu messen, und/oder ii) zweite Messmittel (M2), die geeignet sind, um zwischen der zweiten (L2) und der dritten (L3) Leitung angeschlossen zu sein, um einen zweiten Spannungsunterschied (V2) zwischen ihnen zu messen, **dadurch gekennzeichnet, dass** die Erfassungsvorrichtung iii) Verarbeitungsmittel (MT) umfasst, die eingerichtet sind, um zu bestimmen, ob mindestens einer des ersten (V1) und des zweiten (V2) Spannungsunterschieds zu einem entsprechenden Bereich von Werten gehört, und, wenn nicht, ein Alarmsignal zu erzeugen, das einen Anschlussfehler an der Erdleitung (LT) meldet.

2. Elektrisches Verbindungssystem (CV) nach Anspruch 1, **dadurch gekennzeichnet, dass** das erste (Z1) und zweite (Z2) Impedanzglied Teil der Erfassungsvorrichtung (D) sind.

3. Elektrisches Verbindungssystem (CV) nach Anspruch 1, **dadurch gekennzeichnet, dass** das erste (Z1) und das zweite (Z2) Impedanzglied außerhalb der Erfassungsvorrichtung (D) sind.

4. Elektrisches Verbindungssystem (CV) nach einem der Ansprüche 1 und 2, **dadurch gekennzeichnet, dass** jeder entsprechende Bereich von Werten von dem Hauptspannungsunterschied (V0) abhängt und von einem Verhältnis, das von dem ersten (Z1) und dem zweiten (Z2) Impedanzglied abhängt.

5. Elektrisches Verbindungssystem (CV) nach einem der Ansprüche 1 bis 3, **dadurch gekennzeichnet, dass** bei Vorliegen einer ersten (L1) und zweiten (L2) Leitung, die geeignet sind, jeweils mit dem Nullleiter (LN) und dem Phasenleiter (LP) gekoppelt zu sein, die Verarbeitungsmittel (MT) eingerichtet sind, um zu bestimmen, ob der erste Spannungsunterschied (V1) zu einem entsprechenden ersten Bereich von Werten gehört.

6. Elektrisches Verbindungssystem (CV) nach einem der Ansprüche 1 bis 3, **dadurch gekennzeichnet, dass** bei Vorliegen einer ersten (L1) und zweiten (L2) Leitung, die geeignet sind, jeweils mit dem Phasenleiter (LP) und Nullleiter (LN) gekoppelt zu sein, die Verarbeitungsmittel (MT) eingerichtet sind, um vor dem Beginnen des Aufladens zu bestimmen, ob der zweite Spannungsunterschied (V2) zu einem entsprechenden zweiten Bereich von Werten gehört.

7. Elektrisches Verbindungssystem (CV) nach einem der Ansprüche 4 und 5, **dadurch gekennzeichnet, dass** die Verarbeitungsmittel (MT) eingerichtet sind, um davon auszugehen, dass der Hauptspannungsunterschied (V0) der größte der Spannungsunterschiede unter dem ersten und zweiten Spannungsunterschied ist.

8. Elektrisches Verbindungssystem (CV) nach einem der Ansprüche 1 bis 6, **dadurch gekennzeichnet, dass** bei Vorliegen eines Hauptspannungsunterschieds (V0) vom Wechselspannungstyp die ersten Messmittel (M1) i) Teilungsmittel (MD) vom analogen Typ umfassen und eingerichtet sind, um den ersten Spannungsunterschied (V1) durch eine Konstante zu teilen, die ausgewählt ist, um ein erstes analoges Zwischensignal zu liefern, ii) Gleichrichtmittel (MR) vom analogen Typ umfasst, die eingerichtet sind, um das erste analoge Zwischensignal gleichzurichten, um ein zweites analoges Zwischensignal zu liefern, iii) Filtermittel (MF) vom analogen Typ, die eingerichtet sind, um ein Tiefpassfilter an das zweite analoge Zwischensignal anzuwenden, um ein drittes analoges Zwischensignal nahe Gleichspannung zu liefern, und iv) Umwandlungsmittel (MC), die eingerichtet sind, um das dritte analoge Zwischensignal umzuwandeln, um ein digitales Ausgangssignal zu liefern, das für den ersten Spannungsunterschied (V1) repräsentativ ist.

9. Elektrisches Verbindungssystem (CV) nach einem der Ansprüche 1 bis 7, **dadurch gekennzeichnet, dass** bei Vorliegen eines Hauptspannungsunterschieds (V0) vom Wechselspannungstyp die zweiten Messmittel (M2) i) Teilungsmittel (MD) vom analogen Typ umfassen, die eingerichtet sind, um den zweiten Spannungsunterschied (V2) durch eine Konstante zu teilen, die ausgewählt ist, um ein erstes analoges Zwischensignal zu liefern, ii) Gleichrichtmittel (MR) vom analogen Typ, die eingerichtet sind, um das erste analoge Zwischensignal gleichzurichten, um ein zweites analoges Zwischensignal zu liefern, iii) Filtermittel (MF) vom analogen Typ, die eingerichtet sind, um ein Tiefpassfilter an das zweite analoge Zwischensignal anzuwenden, um ein drittes analoges Zwischensignal nahe Gleichspannung zu liefern, und iv) Umwandlungsmittel (MC), die eingerichtet sind, um das dritte analoge Zwischensignal umzuwandeln, um ein digitales Ausgangssignal zu liefern, das für den zweiten Spannungsunterschied (V2) repräsentativ ist.

10. Elektrisches Verbindungssystem (CV) nach einem der vorhergehenden Ansprüche, **dadurch gekennzeichnet, dass** es aus einer Gruppe ausgewählt ist, die mindestens ein Batterieladegerät, eine Wandsteckdose und ein Anschlusskabel umfasst.

11. System (V), das mindestens eine elektrische Batterie (BA) umfasst, die an einer Ladestelle (PC) aufladbar ist, **dadurch gekennzeichnet, dass** es ein elektrisches Verbindungssystem (CV) nach einem der Ansprüche 9 und 10 umfasst.

12. System nach Anspruch 11, **dadurch gekennzeichnet, dass** es ein Fahrzeug bildet.

13. System nach Anspruch 12, **dadurch gekennzeichnet, dass** es ein Kraftfahrzeug vom hybriden oder vollelektrischen Typ bildet.

## Claims

1. An electrical connector system (CV) suitable to be coupled to an electrical supply network (RA) comprising an earth line (LT), and at least one phase line (LP) and a neutral line (LN) having a principal voltage differential (V0), said electrical connector system (CV) comprising first (L1) and second (L2) lines suitable to be coupled respectively to said neutral (LN) and phase (LP) lines, or vice versa, and a third line (L3) suitable to be coupled to said earth line (LT), said connector system comprising a detection device (D), said first (L1) and third (L3) lines being coupled by a first impedance (Zl); said second (L2) and third (L3) lines being coupled by a second impedance (Z2); and the detection device (D) including i) first measuring means (M1) suitable to be connected between said first (L1) and third (L3) lines, so as to measure a first voltage differential (V1) between them, and/or ii) second measuring means (M2) suitable to be connected between said second (L2) and third (L3) lines, so as to measure a second voltage differential (V2) between them, **characterized in that** the detection device includes iii) processing means (MT) arranged so as to determine whether at least one of said first (V1) and second (V2) voltage differentials belongs to a corresponding range of values, and, if not, to generate a warning signal signalling an earth line (LT) connection fault.

2. The electrical connector system (CV) according to Claim 1, **characterized in that** the first (Z1) and second (Z2) impedances form part of the detection device (D).

3. The electrical connector system (CV) according to Claim 1, **characterized in that** the first (Z1) and second (Z2) impedances are external to the detection device (D).

4. The electrical connector system (CV) according to one of Claims 1 and 2, **characterized in that** each corresponding range of values is a function of said principal voltage differential (V0) and of a ratio as a function of said first (Z1) and second (Z2) impedances.

5. The electrical connector system (CV) according to one of Claims 1 to 3, **characterized in that** in the presence of first (L1) and second (L2) lines suitable to be coupled respectively to said neutral (LN) and phase (LP) lines, said processing means (MT) are arranged so as to determine whether said first voltage differential (V1) belongs to a first corresponding range of values.

6. The electrical connector system (CV) according to one of Claims 1 to 3, **characterized in that** in the presence of first (L1) and second (L2) lines suitable to be coupled respectively to said phase (LP) and neutral (LN) lines, said processing means (MT) are arranged so as to determine, before the recharging begins, whether said second voltage differential (V2) belongs to a second corresponding range of values.

7. The electrical connector system (CV) according to one of Claims 4 and 5, **characterized in that** said processing means (MT) are arranged so as to consider that said principal voltage differential (V0) is the greatest of the voltage differentials among said first and second voltage differentials.

8. The electrical connector system (CV) according to one of Claims 1 to 6, **characterized in that** in the presence of a principal voltage differential (V0) of alternative type, said first measuring means (M1) include i) division means (MD) of analog type and arranged to divide said first voltage differential (V1) by a constant selected so as to deliver a first intermediate analog signal, ii) rectifying means (MR) of analog type and arranged so as to rectify said first intermediate analog signal in order to deliver a second intermediate analog signal, iii) filtering means (MF) of analog type and arranged to apply a lowpass filtering to said second intermediate analog signal in order to deliver a third intermediate analog signal close to continuous, and iv) conversion means (MC) arranged to convert said third intermediate analog signal in order to deliver a digital output signal, representative of said first voltage differential (V1).

9. The electrical connector system (CV) according to one of Claims 1 to 7, **characterized in that** in the presence of a principal voltage differential (V0) of alternative type, said second measuring means (M2) include i) division means (MD) of analog type and arranged to divide said second voltage differential (V2) by a constant selected in order to deliver a first intermediate analog signal, ii) rectifying means (MR) of analog type and arranged to rectify said first intermediate analog signal in order to deliver a second intermediate analog signal, iii) filtering means (MF) of analog type and arranged to apply a lowpass filtering to said second intermediate analog signal in order to deliver a third intermediate analog signal close to continuous, and iv) conversion means (MC) arranged to convert said third intermediate analog signal in order to deliver a digital output signal, representative of said second voltage differential (V2).

10. The electrical connector system (CV) according to one of the preceding claims, **characterized in that** it is selected from a group including at least one battery charger, one wall connection socket and one connection cable.

11. A system (V) comprising at least one electric battery (BA) which is rechargeable at a recharging point (PC), **characterized in that** it includes an electrical connector system (CV) according to one of Claims 9 and 10.

12. The system according to Claim 11, **characterized in that** it constitutes a vehicle.

13. The system according to Claim 12, **characterized in that** it constitutes a motor vehicle of hybrid type or of entirely electric type.
